# EUROPEAN PATENT SPECIFICATION

(11) **EP 1 095 734 B1**
(45) Date of publication and mention of the grant of the patent: **07.10.2009**
(21) Application number: 98961632.1
(22) Date of filing: 28.12.1998
(51) Int. Cl.: B24B 37/00

(54) **POLISHING MACHINE**
POLIERVORRICHTUNG
DISPOSITIF DE POLISSAGE

(30) Priority: 26.12.1997 JP 36903197
(43) Date of publication of application: 02.05.2001
(73) Proprietor: EBARA CORPORATION, Tokyo 144-8510 (JP)
(72) Inventor: TOGAWA, Tetsuji, Ebara Corporation, Tokyo 144-8510 (JP); YAMAGUCHI, Kuniaki, Ebara Corporation, Tokyo 144-8510 (JP)
(74) Representative: Wagner, Karl H.
(86) International application number: PCT/JP1998/005992
(87) International publication number: WO 1999/033612

(56) References cited:
- EP-A- 0 774 323
- EP-A- 0 796 702
- JP-A- 7 201 786
- JP-A- 7 223 142
- JP-A- 8 257 899
- JP-A- 9 057 610
- JP-A- 9 174 420
- JP-A- 61 188 071
- JP-U- 1 138 659
- JP-U- 1 164 060
- US-A- 5 421 768
- US-A- 5 456 627
- US-A- 5 660 581
- US-A- 5 679 063
- PATENT ABSTRACTS OF JAPAN vol. 011, no. 147 (P-575), 14 May 1987 (1987-05-14) -& JP 61 284737 A (GOKOU EIZOU KAGAKU KENKYUSHO:KK), 15 December 1986 (1986-12-15)

## Description

### TECHNICAL FIELD

The present invention relates to a polishing machine comprising a turntable having a polishing surface for polishing a semiconductor wafer or the like, and a polishing liquid supply unit for supplying a polishing liquid onto the polishing surface of the turntable.

### BACKGROUND OF THE INVENTION

In a semiconductor wafer manufacturing process, a polishing machine is used to planarize semiconductor wafer surfaces.

The polishing machine of this kind comprises a turntable having a polishing surface and adapted to be turned at a predetermined rotating speed, a wafer carrier that holds a semiconductor wafer, rotates at a predetermined rotating speed and presses a surface of the semiconductor wafer against the polishing surface of the turntable onto which a polishing liquid is being supplied so as to polish the surface of the semiconductor wafer, a dressing tool that is brought into contact with the polishing surface of the turntable while supplying a dressing liquid onto the polishing surface of the turntable to dress the polishing surface, and an airtight housing containing the turntable, the wafer carrier and the dressing tool therein.

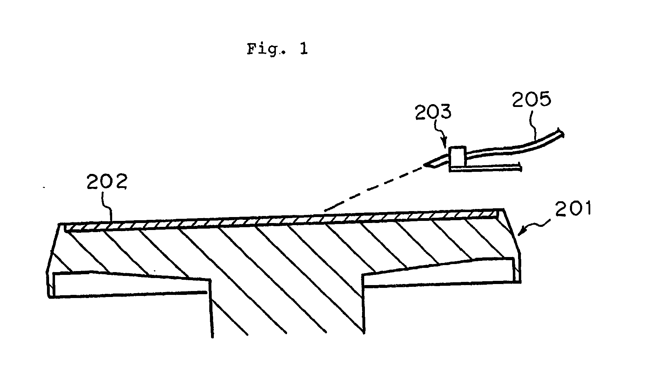

As shown in Fig. 1, in a conventional polishing machine, a polishing surface of a turntable 201, which polishing surface is usually formed by attaching a polishing pad 202 to the upper surface of the turntable 201, is supplied with various kinds of liquids including a polishing liquid and a dressing liquid which are needed for performing certain operations such as polishing of semiconductor wafers, dressing of the polishing surface and so on through a nozzle means 203 which is set above the turntable and connected to a liquid supply tube means 205.

However, this conventional polishing machine has the following problems.
(1) The nozzle means 203 and the liquid supply tube means 205 which are fixedly held above the turntable 201 hinder maintenance work which includes changing the polishing pad 202 attached to the upper surface of the turntable 201 to a new one.
(2) Although it is desired that the liquid discharged from the nozzle 203 falls onto the polishing surface of the turntable 201 at a position suitable for the liquid to be appropriately spread over the polishing surface of the turntable 201 by a centrifugal force, i.e., a position near the center of rotation of the turntable 201, the position on the polishing surface of the turntable 201 where the liquid falls may be different from such a desired position depending on the flow rate and velocity of the discharged liquid.

Further, reference is made to EP 0 774 323 A which describes an apparatus for polishing substrates, in which at least two substrates are to be polished. The apparatus shows a turntable having a polishing surface and a liquid supply system for supplying a liquid such a polishing liquid onto said polishing surface. The liquid supply system has a movable arm, and a nozzle supported thereon to discharge, the liquid onto said polishing surface. The movable arm is capable of being moved between a liquid supply position, in which the nozzle is positioned above a portion of said polishing surface onto which the liquid is to be discharged, and at least one retracted position, in which the nozzle is positioned radially outside said periphery of said polishing surface.

The present invention has been made in view of the prior art mentioned above and the problems associated therewith. It is therefore an object of the present invention to provide a polishing machine with a liquid supply system that does not hinder maintenance work such as the exchange of polishing pads and is capable of positively supplying a liquid at an optimum position on a polishing surface of a turntable.

### DISCLOSURE OF THE INVENTION

According to the present invention, a polishing machine as set forth in claim 1 is provided. Further embodiments of the invention are disclosed in the dependent claims. In particular, a liquid supply system comprising a movable arm, and a nozzle movably supported on the movable arm to supply a liquid onto a polishing surface of a turntable, is provided.

The movable arm is movable between a liquid supply position whereby the nozzle is positioned substantially vertically above a portion of the polishing surface onto which the liquid is to be discharged, and at least one retracted position whereby the nozzle is positioned outside the periphery of the turntable. The polishing machine further comprises a holding device for holding the arm at either the liquid supply position or the retracted position.

### BRIEF DESCRIPTION OF THE DRAWINGS

Fig. 1 is a schematic side elevation of an arrangement of a turntable and a nozzle in a conventional polishing machine;
Fig. 2 is a schematic plan view of a polishing machine in a preferred embodiment of the present invention;
Fig. 3 is an enlarged plan view of a turntable and an arm with a liquid supply nozzle unit included in the polishing machine of the preferred embodiment;
Fig. 4 is a schematic sectional view taken along a line 4-4 in Fig. 3;
Fig. 5 is a plan view, similar to Fig. 3, showing a plurality of positions where the arm with the nozzle unit is positioned;
Fig. 6 is a partly cutaway plan view of the arm with the nozzle unit;
Fig. 7 is a partly cutaway side elevation of the arm with the nozzle unit;
Fig. 8 is a plan view of an arm with the nozzle unit in accordance with a second embodiment of the present invention;
Fig. 9 is a side elevation of the arm shown in Fig. 8;
Fig. 10 is a side elevation of a movable nozzle included in the nozzle unit of the arm shown in Fig. 9;
Fig. 11 is a sectional view taken along a line 11-11 in Fig. 10; and
Fig. 12 is a sectional view taken along a line 12-12 in Fig. 10.

### BEST MODE FOR CARRYING OUT THE INVENTION

The best mode embodiments of the present invention will be described hereinafter with reference to the accompanying drawings.

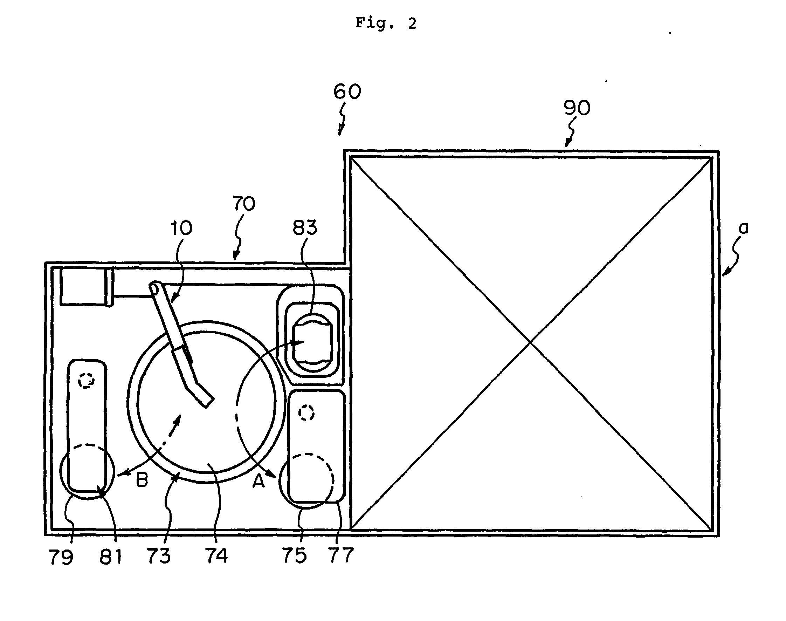

Fig. 2 shows a schematic view of an entire construction of a polishing machine 60 in accordance with an embodiment of the present invention. Referring to Fig. 2, the polishing machine 60 has a polishing unit 70 that performs a polishing operation, and a cleaning unit 90 contiguous with the polishing unit 70. The units 70 and 90 are contained in an airtight housing.

In the polishing unit 70, a turntable 73 is disposed at the center of the polishing unit 70, and a carrier assembly 77 and a dresser assembly 81 are respectively disposed on either side of the turntable 73. The carrier assembly 77 includes a wafer carrier 75 in the shape of a disk and capable of holding a wafer to be polished and of bringing the wafer into contact with a polishing surface of the turntable. The dresser assembly 81 includes a dressing tool 79 in the shape of a disk for dressing the polishing surface of the turntable 73. A workpiece transfer device 83 is disposed near the carrier assembly 77 to transfer a semiconductor wafer from the polishing unit 70 to the cleaning unit 90 and vice versa.

The polishing machine performs a polishing operation and a dressing operation as described below.

A semiconductor wafer to be polished is received through a delivery station a of the cleaning unit 90. The semiconductor wafer is carried through the cleaning unit 90 onto the workpiece transfer device 83 of the polishing unit 70.

The wafer carrier 75 of the carrier assembly 77 is turned from a position shown in Fig. 2 along a path indicated by an arrow A, picks up the wafer from the workpiece transfer device 83 to hold it on its lower surface, rotates about its axis while returning along the path indicated by the arrow A to a position above the turntable 73, and is then lowered to press the wafer against a polishing pad 74 attached to the upper surface of the turntable for the polishing operation. During the polishing operation, a polishing liquid is supplied onto the polishing pad 74 through a liquid supply arm 10.

After the polishing operation has been completed, the semiconductor wafer is returned to the work transfer device 83 so that the wafer is cleaned and dried by the cleaning unit 90 and, thereafter, taken outside through the delivery station a.

After the polishing operation has been completed, the dressing tool 79 is pressed against the polishing pad while being rotated about its axis and swung along the path designated by an arrow B over the turn table 73 so as to dress the polishing pad 74. During the dressing operation, a dressing liquid is supplied onto the polishing pad 74 through the liquid supply arm 10 the detail of which is explained hereinafter.

The polishing machine according to the embodiment is provided with a liquid supply system for supplying a polishing liquid, a dressing liquid and so on which will be described hereinafter. However, prior to describing the liquid supply system, a liquid draining system will briefly be explained as follows.

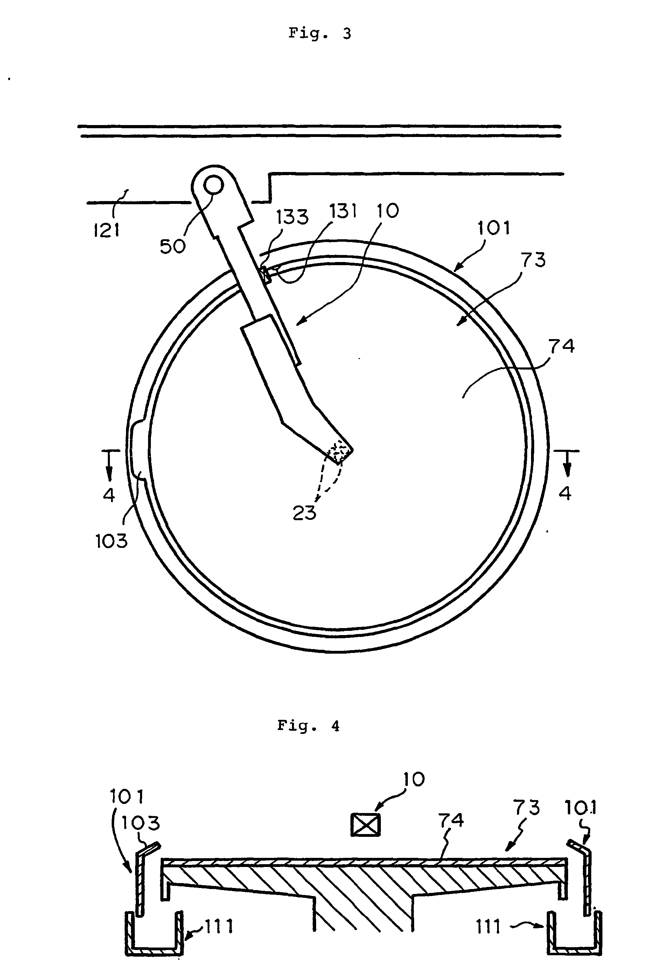

Referring to Figs. 3 and 4, the polishing machine according to the embodiment of the present invention is provided with a splash cover 101 to prevent a liquid such as the polishing liquid supplied onto the turn table 73 by the liquid supply system from scattering out of the periphery of the turntable 73 as the turntable 73 is rotated. The splash cover 101 is provided with a notch 103. An annular trough 111 is disposed under the periphery of the turntable 73. The liquid stopped by the splash cover 101 is collected in the annular trough 111 and is drained from the polishing unit 70 through a drain pipe, not shown.

The liquid supply system will now be described. The liquid supply system includes the liquid supply arm 10. The liquid supply arm 10 has one end portion supported by a pivot shaft 50 on a frame 121. A nozzle assembly 40 comprising four nozzles 23 for selectively discharging a polishing liquid or a dressing liquid is held on the other end portion of the liquid supply arm 10.

A detent mechanism 15 is provided near the pivot shaft 50 supporting the liquid supply arm 10. The detent mechanism 15 is able to selectively hold the liquid supply arm 10 at a liquid supply position F (the position shown in Fig. 3) for supplying the liquid, a first retracted position D close to the periphery of the turntable 73 or a second retracted position E radially separated from the periphery of the turntable 73.

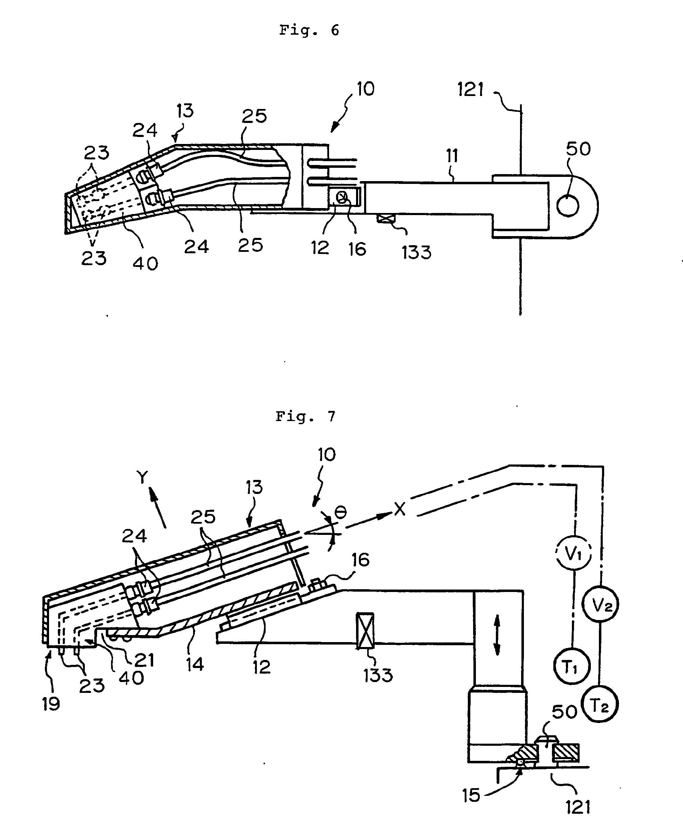

The liquid supply arm 10 has a slide mechanism 12 on the upper surface of its forward end portion, the slide mechanism including a slide member 14. The nozzle assembly 40 is fastened to a forward end portion of the slide member 14 with screws or the like. A cover 13 is detachably attached to the nozzle assembly 40 so as to cover the latter. As shown in Fig. 7, the liquid supply arm 10 can be moved vertically by a hydraulic or pneumatic piston-cylinder actuator.

The detent mechanism 15 comprises an elastic member disposed at a predetermined position on the frame 121, a ball pressed against the lower surface of the base end portion of the liquid supply arm 10 by the elastic member, and recesses formed in the lower surface of the base end portion of the liquid supply arm 10. The liquid supply arm 10 is held at the liquid supply position F, the first retracted position D or the second retracted position E when the ball engages with the corresponding one of the recesses. When a torque exceeding a predetermined value is applied to the liquid supply arm 10, the arm 10 can be released from the position where it was held by the detent mechanism.

The slide member 14 is supported for sliding on the slide mechanism 12. However, the slide member 14 is restrained from sliding off the slide mechanism 12 in a direction X by a detent mechanism similar to the detent mechanism 50.

The nozzle assembly has a nozzle holding member 40. A forward end portion of the nozzle holding member 40 projects downward from an opening 21 formed in a forward end portion of the lower wall of the cover 13. The nozzles 23 are held by the nozzle holding member 40 so that the distal end portions thereof project vertically downward from the lower surface 19 of the nozzle holding member 40. The proximal ends of the nozzles 23 are respectively connected to supply tubes 25 via connectors 24. If the distal ends of the nozzles 23 are flush with the lower surface 19, liquids such as a polishing liquid and dressing liquid discharged from the nozzles 23 have a tendency that little quantities thereof remain on the lower surface 19 of the nozzle holding member due to their surface tension, whereby a mixing of the remaining liquids or a contamination can be brought about. However, in this embodiment, since the distal end portions of the nozzles 23 are projected from the lower surface 19 of the nozzle holding member and are spaced apart from each other, such a mixing or contamination can be avoided.

While the four supply tubes 25 are extended out from the cover 13, they are inclined at a predetermined angle θ to a horizontal plane to prevent the liquids from remaining in the supply tubes 25.

A polishing liquid, a dressing liquid, a dispersant or cleaning liquid and chemical liquids such as an oxidizer liquid or the like may be supplied to the supply tubes 25, respectively. Specifically, the supply tubes 25 may be connected to different tanks T or sources of such liquids, respectively, as shown in Fig. 7. The number and construction of the nozzles 23 and the supply tubes 25 are determined as required.

The operation of the liquid supply arm 10 will be described hereinafter.

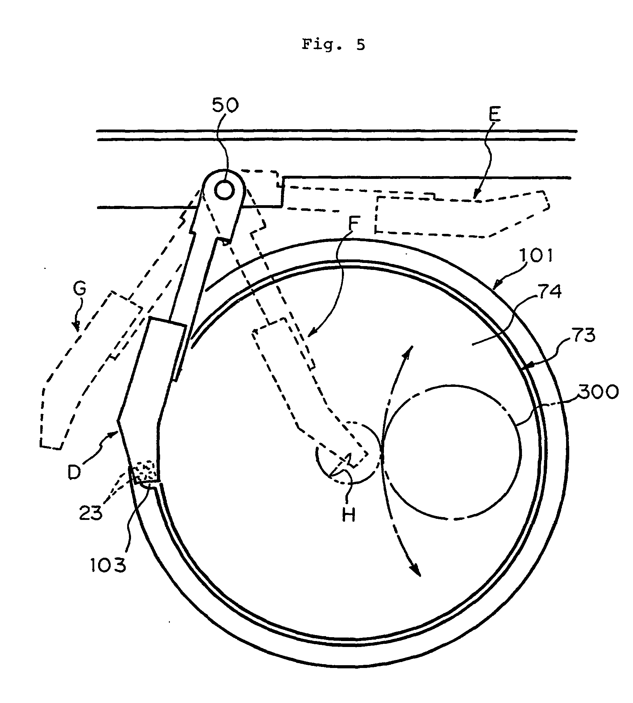

When the liquid supply arm 10 is located and held by the detent mechanism 15 at the liquid supply position F as shown in Fig. 5, the center of the arrangement of the four nozzles 23 coincides with the turning axis of the turntable 73. When polishing the semiconductor wafer by holding the semiconductor wafer on the lower surface of the wafer carrier 75 and pressing the same against the polishing surface of the polishing pad 74 of the turntable 73, the polishing liquid is discharged from a predetermined one of the nozzles 23 held on the forward portion of the liquid supply arm 10.

The polishing liquid thus discharged falls vertically on the central portion of the turntable 73, and is forced to spread uniformly over the entire surface of the turntable 73 by a centrifugal force.

When the dressing tool 79 is operated for a dressing operation, a dressing liquid is discharged through another nozzle 23 for the dressing liquid. The dressing liquid falls vertically on the central portion of the turntable 73 and is forced to spread uniformly over the entire surface of the polishing pad 74.

While the nozzle in the conventional polishing machine as shown in Fig. 1 discharges a liquid obliquely onto the turntable, the nozzles 23 supported by the liquid supply arm discharge liquids vertically onto the central portion of the turntable 73 and, as a result, the liquids can be supplied accurately onto a desired region of the polishing surface of the turntable 73.

The liquids can be vertically supplied onto the turntable 73 by a different method without arranging the nozzles 23 to extend vertically as shown in Fig. 7. In the different method, a flow regulating valves V is provided in the lines connecting the nozzles and the tanks T storing the liquids to control the flow rates of the liquids supplied to the nozzles so that the liquids discharged from the nozzles will instantaneously fall vertically even if the tip end portions of the nozzles are extended obliquely.

When changing the polishing pad 74 attached to the upper surface of the turntable 73 to a new one, the liquid supply arm 10 is turned by hand to the first retracted position D shown in Fig. 5. The liquid supply arm 10 is then held stationary at the first retracted position D by the detent mechanism 15. Consequently, there is nothing immediately above the polishing pad 74 of the turntable 73, so that the change of the polishing pads 74 can easily be conducted.

During the polishing pad change operation, the nozzles 23 supported on the forward end portion of the liquid supply arm 10 located at the first retracted position D are positioned just above the notch 103 of the splash cover 101, whereby liquids which may remain inside and drop from the nozzles 23 after ceasing the supply of the liquids to the nozzles 23 fall through the notch 103 into the annular trough 111 and thus the surroundings of the turntable 73 is not contaminated by the dropping liquids.

The drainage system also makes it possible that a pure water source is additionally connected to the tubes 25 so that pure water can be flowed through the tubes and nozzles after the supply of the polishing liquid, the dressing liquid and so on to clean the tubes and nozzles without contaminating the surroundings of the turntable 73.

The liquid supply arm 10 is moved to the second retracted position E and held by the detent mechanism when it is necessary to carry out maintenance work of the polishing machine which cannot be done with the liquid supply arm 10 located at the liquid supply position F or the first retracted position D, said maintenance work which includes dismounting the nozzle assembly 40 from an arm body 11 of the liquid supply arm to measure supply or discharging rates of the liquids discharged from the nozzles 23, removing pieces of a semiconductor wafer broken on the turntable 73, removing the splash cover 101 to remove the pieces of broken semiconductor wafer from the annular trough 111, inspecting the entire turntable 73 and repairing the liquid supply system.

In this state, nothing overlies the turntable 73 and the splash cover 101 and hence the maintenance work can easily be conducted.

Since the second retracted position E is close to a side wall of the polishing unit 70, the maintenance of the liquid supply system can easily be performed from the outside of the polishing unit 70. A retracted position G shown in Fig. 5 may be used instead of the second retracted position E.

The discharging rate at which the liquid is discharged through each nozzle 23 must be measured to adjust the rate to an appropriate value. In this embodiment, the discharging rate is measured by either of the following two methods.

In a first measuring method, the liquid discharged from each nozzle 23 is directly measured by a graduated cylinder or the like. The measurement may be carried out by for example placing the liquid supply arm 10 at the first retracted position D or removing the nozzle unit 40 together with the slide member 14 from the liquid supply arm and placing it on a place convenient for the measurement. To remove the nozzle assembly from the arm 10, screws 16 (Figs. 6 and 7) are first removed and then the nozzle assembly with the slide member 14 is moved in the direction X to thereby be separated from the arm.

In a second measuring method, the cover 13 is pulled in the direction designated by an arrow Y to remove the cover 13 from the slide member 14, the supply tubes 25 are then disconnected from the connector 24, the free end portions of the supply tubes 25 are moved to a place convenient for the measurement and, thereafter, the flow rates of the liquids discharged from the free ends are measured.

The second measuring method does not measure quantities of the liquids discharged from the nozzles 23. Therefore, it is possible that a discharging rate measured by the second measuring method may include an error greater than an error which may be included in the measurement by the first measuring method. However, the second measuring method is more convenient and simpler than the first measuring method where slide member 14 and associated elements are removed from the arm body 11 of the liquid supply arm.

In this embodiment, the liquid supply arm 10 is turned on the pivot shaft 50 and the position of the liquid supply arm 10 can easily be detected by a position sensor combined with the pivot shaft 50. Therefore, it is possible to improve the polishing machine in terms of safety by providing an interlocking mechanism which controls the drive of the polishing machine so that, when it is detected that the liquid supply arm is not appropriately located at the liquid supply position F in a polishing operation, the driving of the polishing machine is stopped. For example, it is possible to avoid damaging the liquid supply arm 10 and the dressing unit 81 by a collision therebetween which may be brought about by a turn of the dressing unit 81 about its pivot shaft when the liquid supply arm 10 is at a position out of the liquid supply position F.

As shown in Fig. 3, a dog 131 is attached to the splash cover 101 at a predetermined position, and a sensor 133 is attached to the arm body 11 at a position which is close to and opposite the dog 131 when the splash cover 101 is set correctly in place (Figs. 1 and 3) so that it is easy to determine whether the splash cover is set correctly or not. The splash cover 101 is vertically movable and is lowered when performing the maintenance of the turntable 73. If the polishing operation is performed with the splash cover 101 lowered, the polishing liquid and such are scattered around. A drive motor for driving the turntable 73 is therefore adapted to be prevented from being activated when the splash cover 101 is lowered and thus the sensor 133 does not detect the dog 131.

Further, it is possible to lower the splash cover 101 to the predetermined regular position or to raise the arm body 11 by a predetermined distance when the splash cover 101 is raised excessively so that it becomes impossible for the sensor 133 to detect the dog 131. Although in this embodiment both of the arm body 11 and the splash cover 101 are made to be vertically movable, it is possible for the arm body 11 not to move vertically.

The polishing machine in this embodiment has three positions where the liquid supply arm 10 can be held stationary by the detent mechanism 15. However, this invention is not limited to such an arrangement. The polishing machine may have at least one liquid supply position and at least one retracted position.

If the liquid supply arm 10 is arranged to be turned by a piston-cylinder actuator provided between the fixed frame of the polishing machine and the liquid supply arm 10, any mechanism like the detent mechanism 15 for holding the liquid supply arm 10 stationary is not needed. When such a piston-cylinder actuator is employed, a position sensing switch may be associated with the piston-cylinder actuator to sense and control the position of the liquid supply arm 10. A rotary actuator may be employed instead of the piston-cylinder actuator. Further, if the liquid supply arm 10 is driven for turning by a stepping motor, the liquid supply arm 10 can accurately be stopped and held at desired positions without any detent mechanism.

In this embodiment, the liquid supply position F is such a position that makes the center of the arrangement of the four nozzles 23 in the forward end portion of the liquid supply arm 10 coincides with the turning axis of the turntable 73. However, the liquid supply position F is not limited to such a position. For example, when the periphery of the semiconductor wafer 300 is not moved to the center of the turntable 73 in the polishing operation, the center of the arrangement of the four nozzles 23 may, as shown in Fig. 5, be located at any position in a circular center area of the polishing pad having a radius H which is not used for polishing a semiconductor wafer 300. This is because the liquid supplied onto such a circular center area will be appropriately spread over the polishing pad and supplied to the semiconductor wafer 300 which is being polished.

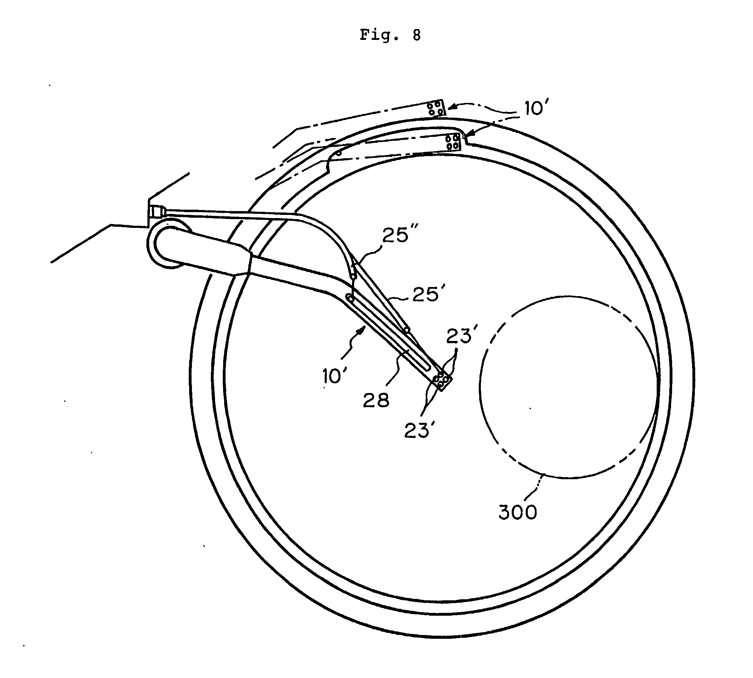

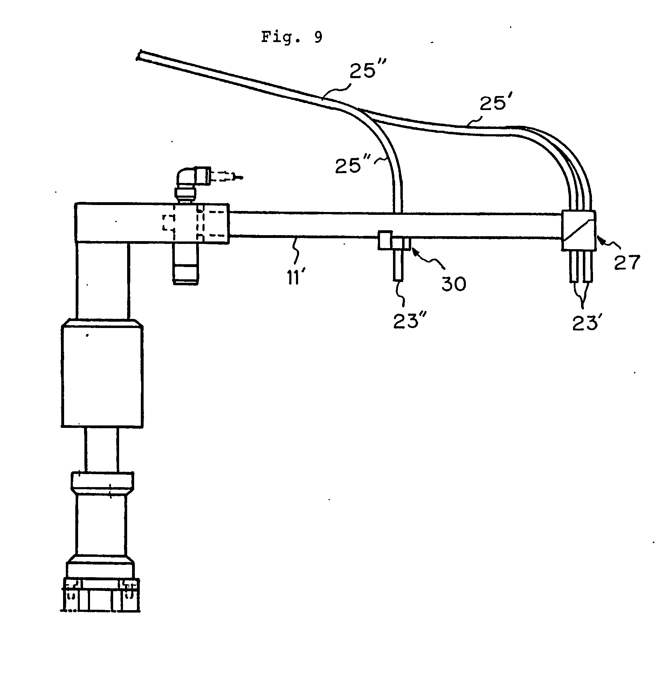

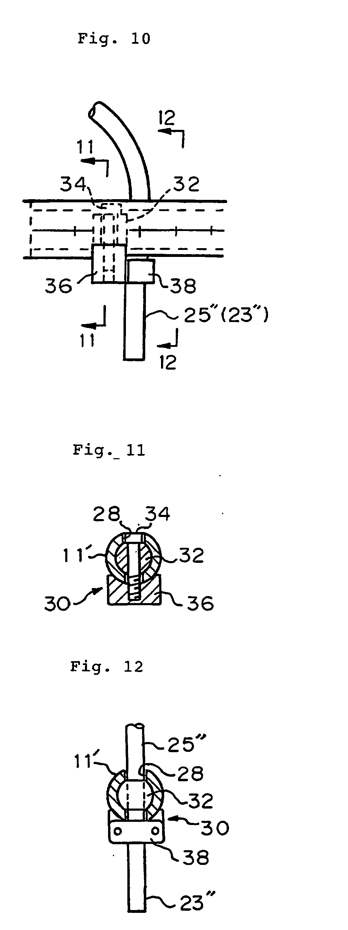

A polishing machine in according with a second embodiment of the present invention is shown in Figs. 8 to 12.

In the second embodiment, a liquid supply arm 10' includes fixed nozzles 23' fixedly held on a forward end portion of a body 11' of the arm 10', and a movable nozzle 23" longitudinally movably supported on the arm body 11'. The fixed nozzles 23' are formed from a tip or free end portions of tubes 25' connected to liquid supply sources including a dressing liquid source (not shown). The free end portions of the tubes 25' are passed through vertical through holes formed in the forward end portion of the liquid supply arm 10' and secured to the liquid supply arm 10' by a fixing member 27. The movable nozzle 23" is formed from a tip or free end portion of a tube 25" connected to a polishing liquid source (not shown). The free end portion of the tube 25" is passed vertically through longitudinal slots 28 formed in the arm body 11' and is held at a desired position by a movable fixing device 30. More specifically, the arm body 11' is a tubular member having a circular cross section and the longitudinal slots 28 are diametrically opposite each other in the vertical direction. The movable fixing device 30 includes a sliding member 32 which has a substantially circular cross section and is longitudinally slidably fitted in the arm body 11', a tube holding member 36 positioned below a lower surface of the arm body 11', and a bolt 34 which passes through the longitudinal slots 28 in the vertical direction and is threadably engaged with the tube holding member 36. The free end portion of the tube 25" passing through the slots 28 is fastened to the tube holding member 36 by a fastening member 38.

The bolt 34 is passed through a vertical hole formed in the sliding member 32 and is threadably engaged with a threaded hole formed in the tube holding member 36. The tube holding member 36 can thus be lifted and lowered relative to the arm body 11' by turning the bolt 34 about its axis so that the sliding member 32 is fixedly engaged with and disengaged from the arm body.

In the embodiment shown in Fig. 8, the movable nozzle 23" is located at a radial position on the polishing surface of the turntable corresponding to the center of a wafer 300 which is being subjected to the polishing operation, while the fixed nozzles are positioned at the center of the polishing surface of the turntable. Although, in this embodiment, only the nozzle for discharging a polishing liquid is made to be movable, any other nozzles may be made to be movable as required. For example, it is preferable that the nozzles for discharging a dispersant liquid and the nozzle for discharging an oxidizer liquid are movable so that those nozzles can be located at the same position as the polishing liquid.

### INDUSTRIAL APPLICABILITY

As is apparent from the foregoing description, according to the present invention, (1) since the liquid supply arm can be located outside the turntable as required, the maintenance work which includes changing the polishing pads can easily be carried out without being hindered by the liquid supply arm thereby shortening the time for the maintenance operation and (2) since the liquids discharged from the nozzles are directed vertically, the liquids can be appropriately supplied onto a desired position on the turntable.

## Claims

1. A polishing machine (60) comprising:
a turntable (73) having a polishing surface; and
a liquid supply system for supplying a liquid such a polishing liquid onto said polishing surface;
wherein said liquid supply system comprises a movable arm (10'), and a nozzle (23") supported on said movable arm to discharge the liquid onto said polishing surface;
said movable arm (10') is capable of being moved between a liquid supply position (F) whereby said nozzle (23") is positioned substantially vertically above a portion of said polishing surface onto which the liquid is to be discharged, and at least one retracted position (E, G) whereby said nozzle (23") is positioned radially outside said periphery of said polishing surface;
said nozzle (23") is capable of being moved on said movable arm (10') so that the position of said nozzle on said movable arm positioned at said liquid supply position(F) can be adjusted relative to said polishing surface in a radial direction of said polishing surface.

2. A polishing machine according to claim 1, wherein said liquid supply system includes a liquid supply tube (25") which is detachably connected to a proximal end of said nozzle (23") and slants upward from the proximal end of said nozzle (23").

3. A polishing machine according to claim 1, wherein said movable arm (10') is also capable of being moved to a liquid empty position (D) radially outside the periphery of said polishing surface for emptying the liquid out of said nozzle (23"), and said retracted position (G) is radially outside said liquid empty position.

4. A polishing machine according to claim 1 further comprising an annular splash cover (101) which is movable between an upper position to prevent the liquid supplied on said polishing surface from scattering outside said periphery of said polishing surface and a lower position below a level of said polishing surface.

5. A polishing machine according to claim 4 wherein a liquid drainage member (111) being adapted to receive the liquid emptied out of said nozzle (23") on said movable arm (10') positioned on said liquid emptying position.

6. A polishing machine according to claim 1wherein said liquid supply system includes a flow regulating device that regulates a flow rate of the liquid so that the liquid discharged from the liquid supply nozzle (23") flows down substantially vertically onto said portion of said polishing surface.

7. A polishing machine according to claim 1, wherein the liquid supply system comprises a plurality of nozzles (23") respectively connected to different kinds of liquid sources.

8. A polishing machine according to claim 7, wherein said nozzles (23") are connected to a source of pure water in addition to said different kinds of liquid sources through selector valves to enable said nozzles to be cleaned by passing the pure water therethrough.

9. A polishing machine according to claim 1, wherein said polishing machine further includes a stationary member (121), a piston-cylinder actuator is provided between said movable arm (10') and said stationary member (121) so that said movable arm is moved by said piston-cylinder actuator, and said polishing machine further includes a position sensing switch for sensing the position of said movable arm (10') to conduct a position control of said movable arm.

10. A polishing machine according to claim 4, further comprising a sensor for determining whether or not said annular splash cover (101) is located at said upper position.

## Patentansprüche

1. Eine Poliermaschine (60), die folgendes aufweist:
einen Drehtisch (73) mit einer Polieroberfläche; und
ein Flüssigkeitsliefersystem zum Liefern einer Flüssigkeit, wie einer Polierflüssigkeit auf die Polieroberfläche;
wobei das Flüssigkeitsliefersystem einen bewegbaren Arm (10') und eine Düse (23") aufweist, die an dem bewegbaren Arm getragen wird, um die Flüssigkeit auf die Polieroberfläche auszugeben; wobei der bewegbare Arm (10') in der Lage ist, bewegt zu werden zwischen einer Flüssigkeitslieferposition (F), in der die Düse (23") im Wesentlichen vertikal oberhalb eines Teils der Polieroberfläche, auf die die Flüssigkeit ausgegeben werden soll, positioniert ist, und wenigstens einer zurückgezogenen Position (E, G) in der die Düse (23") radial außerhalb des Umfangs der Polieroberfläche positioniert ist;
wobei die Düse (23") in der Lage ist, an dem bewegbaren Arm (10') bewegt zu werden, so dass die Position der Düse an dem bewegbaren Arm in der Flüssigkeitslieferposition (F) relativ zu der Polieroberfläche in einer Radialrichtung der Polieroberfläche positioniert werden kann.

2. Poliermaschine nach Anspruch 1, wobei das Flüssigkeitsliefersystem einen Flüssigkeitslieferschlauch (25") aufweist, der abnehmbar mit einem proximalen Ende der Düse (23") verbunden ist und sich schräg nach oben von dem proximalen Ende der Düse (23") erstreckt.

3. Poliermaschine nach Anspruch 1, wobei der bewegbare Arm (10') auch in der Lage ist, in eine Flüssigkeitsleerposition (D) radial außerhalb des Umfangs der Polieroberfläche bewegt zu werden, zum Leeren der Flüssigkeit aus der Düse (23"), und wobei die zurückgezogene Position (G) radial außerhalb der Flüssigkeitsleerposition liegt.

4. Poliermaschine nach Anspruch 1, die ferner eine ringförmige Spritzabdeckung (101) aufweist, die bewegbar ist zwischen einer oberen Position , um zu verhindern, dass die an die Polieroberfläche gelieferte Flüssigkeit sich über den Umfang der Polieroberfläche hinaus verteilt, und einer unteren Position, unterhalb eines Niveaus der Polieroberfläche.

5. Poliermaschine nach Anspruch 4, wobei ein Flüssigkeitsablaufglied (111) in der Lage ist, die aus der Düse (23"), die an dem bewegbaren Arm in der Flüssigkeitsleerposition ausgeleerte Flüssigkeit, aufzunehmen.

6. Poliermaschine nach Anspruch 1, wobei das Flüssigkeitsliefersystem eine Strömungsreguliervorrichtung aufweist, die eine Strömungsrate der Flüssigkeit reguliert, so dass die aus der Flüssigkeitslieferdüse (23") ausgegebene Flüssigkeit im wesentlichen vertikal auf den Teil der Polieroberfläche nach unten strömt.

7. Poliermaschine nach Anspruch 1, wobei das Flüssigkeitsliefersystem eine Vielzahl von Düsen (23") aufweist, die jeweils mit unterschiedlichen Arten von Flüssigkeitsquellen verbunden sind.

8. Poliermaschine nach Anspruch 7, wobei die Düsen (23") mit einer Quelle reinen Wassers zusätzlich zu unterschiedlichen Arten von Flüssigkeitsquellen über Auswahlventile verbunden sind, um zu ermöglichen, dass die Düse durch Hindurchleiten von reinem Wasser dort hindurch gereinigt werden.

9. Poliermaschine nach Anspruch 1, wobei die Poliermaschine ferner ein stationäres Glied (121) aufweist, wobei ein Kolben-Zylinderbetätiger zwischen dem bewegbaren Arm (10') und dem stationären Glied (121) vorgesehen ist, so das der bewegbare Arm durch den Kolben-Zylinderbetätiger bewegt wird, und wobei die Poliermaschine ferner einen Positionsabfühlschalter aufweist zum Abfühlen der Position des bewegbaren Arms (10'), um eine Positionskontrolle des bewegbaren Arms durchzuführen.

10. Poliermaschine nach Anspruch 4, die ferner einen Sensor aufweist zum Bestimmen, ob die ringförmige Spritzabdeckung (101) in der oberen Position angeordnet ist oder nicht.

## Revendications

1. Machine à polir (60) comprenant :
un plateau tournant (73) ayant une surface de polissage ; et
un système d'alimentation de liquide pour alimenter un liquide tel qu'un liquide de polissage sur ladite surface de polissage ;
où ledit système d'alimentation de liquide comprend un bras mobile (10'), et une buse (23") supportée sur ledit bras mobile pour déverser le liquide sur ladite surface de polissage ;
ledit bras mobile (10') peut être déplacé entre une position d'alimentation de liquide (F) dans laquelle ladite buse (23') est positionnée sensiblement verticalement au-dessus d'une partie de ladite surface de polissage sur laquelle le liquide doit être déversé, et au moins une position rétractée (E, G) dans laquelle ladite buse (23") est positionnée de manière radiale à l'extérieur de ladite périphérie de ladite surface de polissage ;
ladite buse (23") peut être déplacée sur ledit bras mobile (10') de sorte que la position de ladite buse sur ledit bras mobile positionné à ladite position d'alimentation de liquide (F) peut être ajustée par rapport à ladite surface de polissage dans une direction radiale de ladite surface de polissage.

2. Machine à polir selon la revendication 1, dans laquelle ledit système d'alimentation de liquide comprend un tube d'alimentation de liquide (25") qui est relié de manière détachable à une extrémité proximale de ladite buse (23") et s'incline vers le haut depuis l'extrémité proximale de ladite buse (23").

3. Machine à polir selon la revendication 1, dans laquelle ledit bras mobile (10') peut en outre être déplacé à une position de vidange de liquide (D) radialement à l'extérieur de la périphérie de ladite surface de polissage pour vider le liquide hors de ladite buse (23"), et ladite position rétractée (G) est radialement à l'extérieur de ladite position de vidange de liquide.

4. Machine à polir selon la revendication 1 comprenant en outre un couvercle de protection annulaire (101) qui est mobile entre une position supérieure pour empêcher le liquide alimenté sur ladite surface de polissage de se disperser en dehors de ladite périphérie de ladite surface de polissage et une position inférieure en dessous d'un niveau de ladite surface de polissage.

5. Machine à polir selon la revendication 4, dans laquelle un élément de drainage de liquide (111) est adapté pour recevoir le liquide vidé en dehors de ladite buse (23") sur ledit bras mobile (10') positionné sur ladite position de vidage de liquide.

6. Machine à polir selon la revendication 1, dans laquelle ledit système d'alimentation de liquide comprend un dispositif de régulation d'écoulement qui régule une vitesse d'écoulement du liquide de sorte que le liquide vidé de ladite buse d'alimentation de liquide (23") s'écoule vers le bas sensiblement verticalement sur ladite partie de ladite surface de polissage.

7. Machine à polir selon la revendication 1, dans laquelle le système d'alimentation de liquide comprend une pluralité de buses (23") reliées respectivement à différents types de sources de liquide.

8. Machine à polir selon la revendication 7, dans laquelle lesdites buses (23") sont reliées à une source d'eau pure en plus desdits différents types de sources de liquide grâce à des vannes de sélection pour permettre auxdites buses d'être nettoyées en faisant passer de l'eau pure à travers celles-ci.

9. Machine à polir selon la revendication 1, dans laquelle ladite machine à polir comprend en outre un élément stationnaire (121), un actionneur piston-cylindre est fourni entre ledit bras mobile (10') et ledit élément stationnaire (121) de sorte que ledit bras mobile est déplacé par ledit actionneur piston-cylindre, et ladite machine à polir comprend en outre un commutateur de détection de position pour détecter la position dudit bras mobile (10') pour effectuer un contrôle de position dudit bras mobile.

10. Machine à polir selon la revendication 4 comprenant en outre un capteur pour déterminer si ledit couvercle de protection annulaire (101) est situé à ladite position supérieure.
